# EUROPÄISCHE PATENTANMELDUNG

(11) **EP 2 503 860 A1**
(43) Veröffentlichungstag der Anmeldung: **26.09.2012**
(21) Anmeldenummer: 11002495.7
(22) Anmeldetag: 25.03.2011
(51) Int. Cl.: H05K 1/11, H05K 1/02

(54) **Flexibles Verbindungskabel zur elektrischen Verbindung eines Messwertaufnehmers und einer Auswerteelektronik einer Messbaugruppe**

(71) Anmelder: VEGA Grieshaber KG, 77709 Wolfach (DE)
(72) Erfinder: Ohmayer, Gerd, 77716 Haslach (DE)
(74) Vertreter: Patentanwälte Westphal, Mussgnug & Partner

(57) **Zusammenfassung**

Die Erfindung betrifft ein Verbindungskabel (10), insbesondere zur Verbindung elektrischer Baugruppen (1, 2), welches als flexible Leiterplatte (11) mit wenigstens einer Leiterbahn (3) ausgebildet ist, wobei die flexible Leiterplatte (11) wenigstens zwei aneinander liegende und über wenigstens einen Biegeabschnitt (12) verbundene Leiterplattenabschnitte (13) umfasst und aneinander liegende Bereiche der flexiblen Leiterplatte (11) wenigstens über einen Steg (14) trennbar verbunden sind; erfindungsgemäß ist vorgesehen, dass die Leiterplatte (11) mit einem ersten und zweiten Leiterplattenendabschnitt (15₁, 15₂) und dazwischen liegenden aus einer Anzahl von 2n+1 (n≥1) von im Wesentlichen gleich langen Leiterplattenabschnitten (13₁, 13₂, 13₃, 13₄, 13₅) ausgebildet ist, die Leiterplattenendabschnitte (15₁, 15₂) als Anschlussstellen in Richtung der Leiterplattenabschnitte (13₁, 13₂, 13₃, 13₄, 13₅) gegenüberliegende Biegeabschnitte (12₁, 12₂, 12₃, 12₄) überragend ausgebildet sind, wobei deren Ausdehnung quer zur Richtung der Leiterplattenabschnitte (13₁, 13₂, 13₃, 13₄, 13₅) im Wesentlichen der Breite der aneinander liegenden Leiterplattenabschnitte (13₁, 13₂, 13₃, 13₄, 13₅) entspricht, und die Leiterplattenendabschnitte (15₁, 15₂) mit den benachbarten Biegeabschnitten (12₁, 12₂, 12₃, 12₄) jeweils mit wenigstens einem Steg (14₁, 14₂, 14₃, 14₄) trennbar verbunden sind. Eine weitere Lösung besteht darin, dass die flexible Leiterplatte (11) beginnend mit einem ersten Leiterplattenendabschnitt (15₁) spiralförmig in einer Ebene mit mehreren Spiralgängen (21₁, 21₂, 23₃) nach außen verlaufend und in einem zweiten Leiterplattenendabschnitt (15₂) endend ausgebildet ist, und zwischen den Spiralgängen (21₁, 21₂, 23₃) jeweils Stege (22, 23) vorgesehen sind, welche benachbarte Spiralgänge (21₁, 21₂, 23₃) der Leiterplatte (11) trennbar verbinden. Schließlich wird gemäß einer weiteren Lösung vorgeschlagen, dass zwei flexible Leiterplattenabschnitte (13₁, 13₂) beginnend mit einem die Leiterplattenabschnitte (13₁, 13₂) verbindenden Biegeabschnitt (12) bifilar senkrecht zur Ebene der Leiterplatte (11) spiralförmig mit mehreren Spiralgängen (22) nach außen verlaufend mit Leiterplattenendabschnitten (15₁, 15₂) endend gerollt ausgebildet sind. Ferner betrifft die Erfindung eine Messbaugruppe mit einem erfindungsgemäßen Verbindungskabel.

## Beschreibung

Die Erfindung betrifft ein Verbindungskabel zu= elektrischen Verbindung eines Messwertaufnehmers und einer Auswerteelektronik einer Messbaugruppe, insbesondere einer Baugruppe für Füllstandsmesstechnik, wobei dieses Verbindungskabel als flexible Leiterplatte mit wenigstens einer Leiterbahn ausgebildet ist gemäß Oberbegriff des Patentanspruchs 1 sowie gemäß Oberbegriff der Patentansprüche 9 und 12. Ferner betrifft die Erfindung eine Messbaugruppe mit einem erfindungsgemäßen Verbindungskabel gemäß Oberbegriff des Patentanspruchs 16.

Aus der DE 198 19 088 A1 ist eine flexible Leiterplatte aus einer eine Vielzahl von Leiterbahnen tragender. Trägerfolie bekannt, die mit dieser Leiterbahnstruktur als Kabelbaum zum elektrischen Kontaktieren einer bestimmten Anordnung elektrischer und elektronischer Komponenten dient. Das Leiterbahnlayout der Leiterplatte ist hinsichtlich seiner räumlichen Ausdehnung gegenüber der einbaufertigen kabelbaumähnlichen Leiterplatte in einer komprimierten Herstellungsanordnung hergestellt, bei welcher in vorbestimmten Abschnitten Biegestellen vorgesehen sind, an denen die angrenzenden Leiterbahnäste aus ihrer Herszellungsanordnung in ihre bestimmungsgemäße Einbauanordnung biegbar sind- Damit lässt sich durch eine Anordnung eines mit solchen Biegestellen verbundenen mäandrierenden Leiterbahnastes durch dessen Aufbiegen ein langer Leiterbahnast realisieren.

Der Nachteil einer solchen bekannten flexiblen Leiterplatte besteht darin, dass nur eine bestimmte Verwendung möglich ist, da das Layout dieser Leiterplatte hieran angepasst ist.

Auch bei Messbaugruppen im Bereich Füllstandsmesstechnik besteht dieser Nachteil, dass die in einem zylindrischen Gehäuse auf gegenüberliegenden Stirnseiten eines solchen Gehäuses angeordneten Messwertaufnehmer und Auswerteelektronik für unterschiedliche Gehäuselängen auch unterschiedliche Längen von Verbindungskabeln erforderlich sind, die einen Messwertaufnehmer und eine Auswerteelektronik verbinden. Daher erfordern unterschiedliche Baulängen solcher Messbaugruppen unterschiedlich lange Verbindungskabel.

Es ist Aufgabe der vorliegenden Erfindung, ein Verbindungskabel der eingangs genannten Art anzugeben, das eine breite Anwendungsmöglichkeit zulässt, insbesondere ohne die genannten Nachteile für die Anwendung in Messbaugruppen mit unterschiedlichen Baulängen geeignet ist.

Diese Aufgabe wird zunächst gelöst durch ein Verbindungskabel mit den Merkmaler des Patentanspruchs 1.

Ein sclches Verbindungskabel zur elektrischen Verbindung eines Messwertaufnehmers und einer Auswerteelektronik einer Messbaugruppe, insbesondere einer Baugruppe für Füllstandsmesstechnik, welches als flexible Leiterplatte mit wenigstens einer Leiterbahn ausgebildet ist und die flexible Leiterplatte wenigstens zwei aneinander liegende und über wenigstens einen Biegeabschnitt verbundene Leiterplattenabschnitte umfasst sowie aneinander liegende Bereiche der flexiblen Leiterplatte wenigstens über einen Steg trennbar verbunden sind, zeichnet sich erfindungsgemäß dadurch aus, dass die Leiterplatte mit einem ersten und zweiten Leiterplattenendabschnitt und dazwischen liegenden aus einer Anzahl von 2n+1 (n≥1) von im Wesentlichen gleich langen Leiterplattenabschnitten ausgebildet ist, die Leiterplattenendabschnitte als Anschlussstellen in Richtung der Leiterplattenabschnitte gegenüberliegende Biegeabschnitte überragend ausgebildet sind, wobei deren Ausdehnung quer zur Richtung der Leiterplattenabschnitte im Wesentlichen der Breite der aneinander liegenden Leiterplattenabschnitte entspricht, der erste Leiterplattenabschnitt als Anschlussstelle mit dem Messwertaufnehmer und der zweite Leiterplattenabschnitt als Anschlussstelle mit der Auswerteelektronik verbunden ist, und die Leiterplattenendabschnitte mit den benachbarten Biegeabschnitten jeweils mit wenigstens einem Steg trennbar verbunden sind, wodurch eine Verlängerung des Verbindungskabel zur Anpassung von dessen Länge an den Abstand zwischen dem Messwertaufnehmer und der Auswerteelektronik ermöglicht wird.

Mit dem erfindungsgemäßen Verbindungskabel können unterschiedliche Baulängen zwischen elektrischen Baugruppen überbrückt werden. In der Herstellungsanordnung entspricht das erfindungsgemäße Verbindungskabel quasi einer Standardlänge, sollte jedoch diese Standardlänge nicht ausreichen, können zur Verlängerung durch Brechen der Stege die entsprechende Anzahl von Leiterbahnabschnitten an den Biegeabschnitten aufgefaltet werden. Die Verlängerung erfolgt dabei stufenartig mit einer Länge, die jeweils im Wesentlichen der Länge der Leiterplattenabschnitte entspricht. Damit kann aus einem Verbindungskabel mit kurzer Standardlänge ohne Umkonfektionierung ein verlängertes Verbindungskabel hergestellt werden, wobei in Abhängigkeit der Anzahl der Leiterplattenabschnitte beliebige Ausfaltlängen erreichbar sind.

Besonders geeignet ist die Verwendung eines solchen erfindungsgemäßen Verbindungskabels im Bereich der Messtechnik, wo Ein Messwertaufnehmer und eine Auswerteelektronik einer Messbaugruppe verbunden werden und je nach Einsatzbereich verschiedene Baulängen zwischen solchen diesen elektrischen Baugruppen überbrückt werden müssen.

Mit einem solchen erfindungsgemäßen Verbindungskabel ist es nun nicht mehr erforderlich, unterschiedliche Vorbaugruppen in der Fertigung herzustellen, die sich nur in ihrer Baulänge unterscheiden würden.

Weiterhin erlaubt ein solches erfindungsgemäße Verbindungskabel die Bestückung von elektrischen und/oder elektronischen Bauelementen auf der flexiblen Leiterplatte, so dass auch die Möglichkeit einer automatischen Konfektionierung oder Bestückung besteht.

Das erfindungsgemäße Verbindungskabel kann in kurzer Zeit mit hohen Stückzahlen und einem hohen Automatisierungsgrad kostengünstig hergestellt werden.

In einer Ausgestaltung der Erfindung gemäß der ersten Lösung sind die Leiterplattenendabschnitte als Anschlussstellen im Wesentlichen rechteckförmig ausgebildet. Da diese Anschlussstellen über einen Steg mit dem benachbarten Biegeabschnitt trennbar verbunden sind, führt die Rechteckform des Leiterplattenendabschnittes zu einer einfachen Handhabung, wenn ein solcher Steg zum Auffalten eines Leiterplattenabschnittes gebrochen werden soll.

Das erfindungsgemäße Verbindungskabel besteht im Herstellungszustand aus mindestens drei Leiterplattenabschnitten, das im vollständig ausgefalteten Zustand nahezu der dreifachen Länge der Standardlänge entspricht. Die nächste Baugröße besteht aus wenigstens fünf (2n+1, n≥3) Leiterplattenabschnitten, bei der gemäß einer Weiterbildung der Erfindung die Leiterplattenendabschnitte jeweils mit allen benachbarten Biegestellen über trennbare Stege verbunden sind. Damit lässt leicht durch Brechen der entsprechenden Stege die Standardlänge um die Länge von zwei Leiterplattenabschnitte verlängern, oder wenn alle Stege gebrochen werden, um die Länge von vier Leiterplattenabschnitten.

Gemäß einer besonders vorteilhaften Weiterbildung der Erfindung können gleichzeitig eine große Anzahl von identischen Verbindungskabeln hergestellt werden, da eine Mehrzahl von Leiterplatten in einem Träger (Nutzen) hinsichtlich der Leiterplattenabschnitte parallel angeordnet sind und benachbarte Leiterplatten jeweils im Bereich der Leiterplattenendabschnitte über Stege trennbar verbunden sind. Solche in einem Nutzen angeordneten erfindungsgemäßen Verbindungskabel können vereinzelt werden, indem die die benachbarten Leiterplattenendabschnitte verbindenden Stege gebrochen werden.

Damit ergibt sich die vorteilhafte Möglichkeit, die Verbindungskabel in dem Nutzen zu bestücken und erst danach zu vereinzeln.

Es bietet sich an, den Nutzen so zu formen, dass die jeweils über einen Steg miteinander verbundenen ersten bzw. zweiten Leitplattenendabschnitte der Leiterplatten jeweils zusammen einen Randabschnitt des Trägers bilden um die Handhabung des Nutzens zu verbessern.

Schließlich können in einer weiteren Ausgestaltung des erfindungsgemäßen Nutzens die die Leiterplattenendabschnitte verbindenden Stege jeweils randseitig der Randabschnitte angeordnet werden. Damit können die Schlitze in der Leiterplatte, welche die benachbarten Leiterplattenabschnitte von zwei nebeneinander liegenden verbindungskabeln trennen, bis nahezu an den Rand des Nutzens geführt werden, so dass für diese Stege kein zusätzlicher Herstellungsschritt erforderlich wird.

In vorteilhafter Weise bietet sich an, den Nutzen im Wesentlichen rechteckförmig auszubilden, so dass die beiden Randabschnitte gegenüberliegende Seiten des Nutzens darstellen.

Weiterhin wird die oben genannte Aufgabe auch durch ein Verbindungskabel gemäß den Merkmalen des Patentanspruchs 9 gelöst.

Diese zweitgenannte Lösung schlägt ein Verbindungskabel zur elektrischen Verbindung eines Messwertaufnehmers und einer Auswerteelektronik einer Messbaugruppe vor, welches als flexible Leiterplatte mit wenigstens einer Leiterbahn ausgebildet ist und die erfindungsgemäß beginnend mit einem ersten Leiterplattenendabschnitt spiralförmig in einer Ebene mit mehreren Spiralgängen nach außen verlaufend und in einem zweiten Leiterplattenendabschnitt endend ausgebildet ist, der erste Leiterplattenabschnitt als Anschlussstelle mit dem Messwertaufnehmer und der zweite Leiterplattenabschnitt als Anschlussstelle mit der Auswerteelektronik verbunden ist, und zwischen den Spiralgängen jeweils Stege vorgesehen sind, welche benachbarte Spiralgänge der Leiterplatte trennbar verbinden, wodurch eine Verlängerung des Verbindungskabel zur Anpassung von dessen Länge an den Abstand zwischen dem Messwertaufnehmer und der Auswerteelektronik ermöglicht wird.

Auch bei diesem erfindungsgemäßen Verbindungskabel können unterschiedliche Baulängen realisiert werden, indem ausgehend vom ersten, zentrisch angeordneten Leiterplattenendabschnitt Stege herausgebrochen werden, so dass wenigstens ein Spiralgang aus der Ebene der Spiralstruktur heraus gefaltet bzw. gebogen werden kann. Werden alle die einzelnen Spiralgänge verbindenden Stege gebrochen, ergibt sich eine konische Spiralform des Verbindungskabels mit maximaler Länge des Verbindungskabels. Entsprechend der Anzahl der Spiralgänge ergeben sich unterschiedliche Höhen der konischen Spiralform und damit unterschiedliche Kabellängen.

Gemäß einer Weiterbildung der Erfindung ist es besonders vorteilhaft, wenn das Verbindungskabel jeweils nach einem halben Spiralgang mit einem benachbarte Spiralgänge verbindenden Steg ausgebildet ist, so dass die Stege auf einem Durchmesser der Spiralstruktur liegen, wodurch einerseits eine stabile Struktur erzielt und andererseits ein leichtes Auffalten dieser Struktur ermöglicht wird. In vorteilhafter Weise ist gemäß einer Ausgestaltung der Erfindung wenigstens ein Steg im Bereich des zweiten Leiterplattenendabschnittes vorgesehen. Dies ermöglicht eine verbesserte Handhabung beim Brechen dieses Steges.

Schließlich wird diese Aufgabe auch durch ein Verbindungskabel zur elektrischen Verbindung eines Messwertaufnehmers und einer Auswerteelektronik einer Messbaugruppe mit den Merkmalen des Patentanspruchs 12 gelöst.

Gemäß dieser Lösung zeichnet sich das als flexible Leiterplatte mit wenigstens einer Leiterbahn ausgebildete Verbindungskabel erfindungsgemäß dadurch aus, dass zwei flexible Leiterplattenabschnitte beginnend mit einem die Leiterplattenabschnitte verbindenden Biegeabschnitt bifilar senkrecht zur Ebene der Leiterplatte spiralförmig mit mehreren Spiralgängen nach außen verlaufend mit Leiterplattenendabschnitten endend gerollt ausgebildet sind, ein erster Leiterplattenabschnitt als Anschlussstelle mit dem Messwertaufnehmer und ein zweite Leiterplattenabschnitt als Anschlussstelle mit der Auswerteelektronik verbunden ist, und eine Verlängerung des Verbindungskabels zur Anpassung von dessen Länge an den Abstand zwischen dem Messwertaufnehmer und der Auswerteelektronik durch Entrollen des Verlängerungskabels ermöglicht wird.

Dieses erfindungsgemäße Verbindungskabel lässt sich stufenlos durch vollständiges Entrollen der Spirale bis auf eine maximale Länge verlängern, wobei durch Teilentrollen jede gewünschte Länge erzielbar ist.

In einer Ausgestaltung der Erfindung ist zwischen den Leiterplattenendabschnitten eine Differenz von einem halben Spiralgang vorgesehen, so dass hierdurch die Handhabung beim Entrollen des Verbindungskabels erleichtert wird.

Eine besonders vorteilhafte Weiterbildung der Erfindung ergibt sich, wenn eine Mehrzahl von flexiblen Leiterplatten in einem Träger (Nutzen) parallel angeordnet ist und benachbarte Leiterplatten im Bereich der Spiralgänge und/oder im Bereich der Leiterplattenendabschnitte über Stege trennbar verbunden sind.

Damit kann auch dieses erfindungsgemäße Verbindungskabel in einer großen Anzahl gleichzeitig hergestellt werden und anschließend durch Brechen der Stege vereinzelt werden.

Schließlich ist es besonders vorteilhaft, wenn weiterbildungsgemäß die Leiterplattenendabschnitte als im Wesentlichen rechteckförmige Anschlussstellen ausgebildet sind. Damit ist sowohl eine geometrische einfache Anordnung in dem Nutzen möglich als auch eine gute Handhabung beim Vereinzeln und beim Entrollen gewährleistet.

Eine Messbaugruppe, deren Messwertaufnehmers und Auswerteelektronik mit einem solchen erfindungsgemäßen Verbindungskabel verbunden werden, zeichnet sich gemäß den Merkmalen des Anspruchs 16 dadurch aus, der erste Leiterplattenabschnitt als Anschlussstelle mit dem Messwertaufnehmer und der zweite Leiterplattenabschnitt als Anschlussstelle mit der Auswerteelektronik verbunden ist. Damit kann das erfindungsgemäße Verbindungskabel im Herstellungszustand verwendet werden.

In einer Ausgestaltung der Erfindung ist vorgesehen, dass entweder durch Brechen der Stege des Verbindungskabels und dessen Auffalten oder durch Entrollen des Verbindungskabels eine Verlängerung des Verbindungskabels ermöglicht wird, um die Länge des Verbindungskabels an den Abstand zwischen dem Messwertaufnehmers und der Auswerteelektronik, welche in dem Gehäuse angeordnet sind, anzupassen.

In einer weiteren Ausgestaltung der Erfindung ist das Gehäuse der Messbaugruppe zylinderförmig ausgebildet ist, wobei auf gegenüberliegenden Stirnseiten des zylinderförmigen Gehäuses der Messwertaufnehmer und die Auswerteelektronik angeordnet sind.

Ferner ist es weiterbildungsgemäß vorteilhaft, wenn das Verbindungskabel im aufgefalteten oder entrollten Zustand eine Länge aufweist, bei der der Messwertaufnehmer und die Auswertelektronik vor einer Montage mit dem zylinderförmigen Gehäuse mit dem durch das Gehäuse geführten Verbindungskabel verbindbar sind.

Vorzugsweise ist die Messbaugruppe zur Füllstandsmessung ausgebildet.

Die Erfindung wird nachstehend anhand von Ausführungsbeispielen unter Bezugnahme auf die beigefügten Figuren ausführlich beschrieben. Es zeigen:
- Figur 1: ein Verbindungskabel im Herstellungszustand als Aus-führungsbeispiel der Erfindung mit drei Leiterplat-tenabschnitten, die über zwei Biegeabschnitte mitein-ander verbunden sind,
- Figur 2: ein Verbindungskabel gemäß Figur 1 im aufgefalteten Zustand,
- Figur 3: eine Darstellung eines Trägers (Nutzen) mit mehreren erfindungsgemäßen Verbindungskabeln gemäß Figur 1,
- Figur 4: eine Darstellung einer Verwendung eines Verbindungs-kabels gemäß Figur 1 in seiner Standardlänge zur Ver-bindung eines Messwertaufnehmers und einer Auswerte-elektronik einer Messbaugruppe,
- Figur 5: eine Darstellung einer Messbaugruppe gemäß Figur 4 mit größerer Baulänge, in der das Verbindungskabel vollständig auf eine maximale Länge entfaltet ist,
- Figur 6: ein Verbindungskabel im Herstellungszustand als wei-teres Ausführungsbeispiel der Erfindung mit fünf Lei-terplattenabschnitten,
- Figur 7: ein Verbindungskabel im Herstellungszustand als wei-teres Ausführungsbeispiel der Erfindung mit einer spiralförmigen Struktur,
- Figur 8: eine Darstellung des Verbindungskabels nach Figur 7 im aufgefalteten Zustand,
- Figur 9: ein Verbindungskabel im Herstellungszustand als wei-teres Ausführungsbeispiel der Erfindung mit eine= spiralförmigen Struktur,
- Figur 10: eine Darstellung des Verbindungskabels nach Figur 9 im aufgefalteten Zustand,
- Figur 11: eine Darstellung der Messbaugruppe nach Figur 4 im zusammengebauten Zustand, und
- Figur 12: eine Darstellung der Messbaugruppe nach Figur 5 im zusammengebauten Zustand.

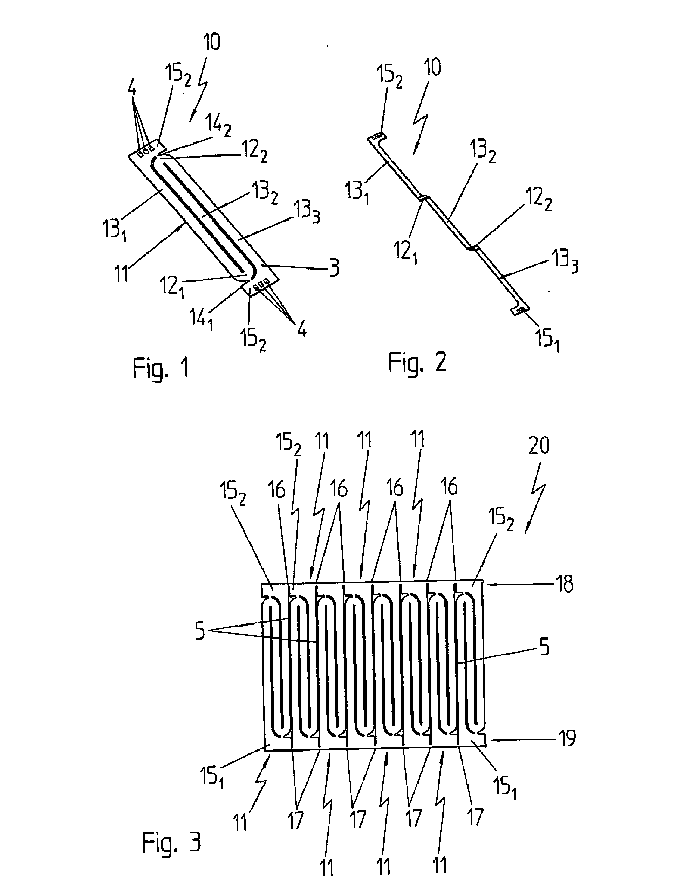

Das Verbindungskabel 10 gemäß Figur 1 wird als flexible Leiterplatte 11 hergestellt und mittels Schlitzen derart strukturiert, dass drei geradlinige Leiterplattenabschnitte 13₁, 13₂ und 13₃ nebeneinander angeordnet und über Biegeabschnitte 12₁ und 12₂ verbunden sind, wobei die gegenüberliegenden Enden der beiden äußeren Leiterplattenabschnitte 13₁ und 13₃ den Biegeabschnitt 12₁ bzw. 12₂ überragen und dort in einen ersten Leiterplaztenendabschnitt 15₁ bzw. in einen zweiten Leiterplattenendabschnitt 15₂ übergehen, wobei diese Leiterplattenendabschnitte 15₁ und 15₂ als rechteckförmige Anschlussstellen des Verbindungskabels 10 ausgebildet sind und sich quer zur Richtung der Leiterplattenabschnitte 13₁, 13₂ und 13₃ über deren gesamte Breite erstrecken, so dass sich insgesamt für diese Leiterplatte 11 eine rechteckförmige Form ergibt. Die Leiterplattenendabschnitte 15₁ und 15₂ sind über Stege 14₁ und 14₂ mit den Biegeabschnitten 12₁ und 12₂ trennbar verbunden.

Auf der Leiterplatte 1 verlaufen zwischen den Leiterplattenendabschnitten 15₁ und 15₂ entlang den Leiterplattenabschnitten 13₁, 13₂ und 13₃ und den Biegeabschnitten 12₁ und 12₂ mehrere Leiterbahnen 3, die in Anschlusspads 4 an den Anschlussstellen 15₁ und 15₂ enden. Solche Leiterplatten 11 werden in bekannter Weise hergestellt und bestehen aus einer leitenden Zwischenlage zwischen zwei hochtemperaturbeständigen Isolierschichten.

Aus Figur 1 ist somit ersichtlich, dass das Layout der Leiterplatte 11 mit den Leiterbahnen 3 einen mäanderförmigen Verlauf aufweist. Durch Brechen der Stege 14₁ und 14₂ werden die Verbindungen zwischen den Leiterplattenendabschnitten 15₁ und 15₂ und den Biegeabschnitten 12₁ und 12₂ getrennt, so dass die Leiterplatte 11 gemäß Figur 2 in ein Verbindungskabel 10 mit maximaler Länge an den Biegeabschnitten 12₁ und 12₂ aufgefaltet werden können.

Figur 3 zeigt einen als rechteckförmigen Träger ausgebildeten Nutzen 20, mit dem mehrere Leiterplatten 11 gemäß Figur 1 zusammengefasst werden und nach deren Vereinzelung als Verbindungkabel 10 verwendet werden können. Damit können gleichzeitig eine große Anzahl von identischen Verbindungskabeln 10 hergestellt werden. Der Einfachheit halber sind die Leiterbahnen auf diesem Träger nicht dargestellt.

Gemäß Figur 3 sind die einzelnen Leiterplattenteile, die jeweils eine Leiterplatte 11 darstellen, hinsichtlich ihrer Leiterplattenabschnitte 13₁ bis 13₃ parallel angeordnet und werden durch ebenso parallel zu den Leiterplattenabschnitten verlaufende Schlitze S bis auf am Rand verbleibende trennbare Stege 16 und 17 getrennt. Diese Stege 16 und 17 verbinden benachbarte Leiterplattenendabschnitte 15₁ und 15₂ und bilden zusammen über den gesamten Träger 20 jeweils gegenüberliegende Randabschnitte 18 und 19 dieses Trägers 20.

Die Vereinzelung der Leiterplatten 11 in Verbindungskabel 10 gemäß Figur 1 erfolgt durch Brechen dieser Stege 16 und 17.

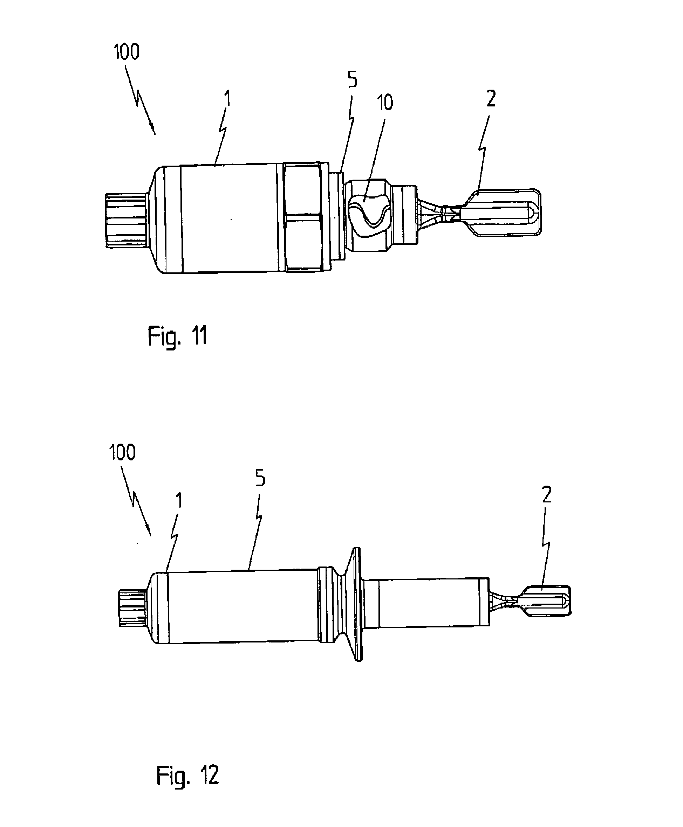

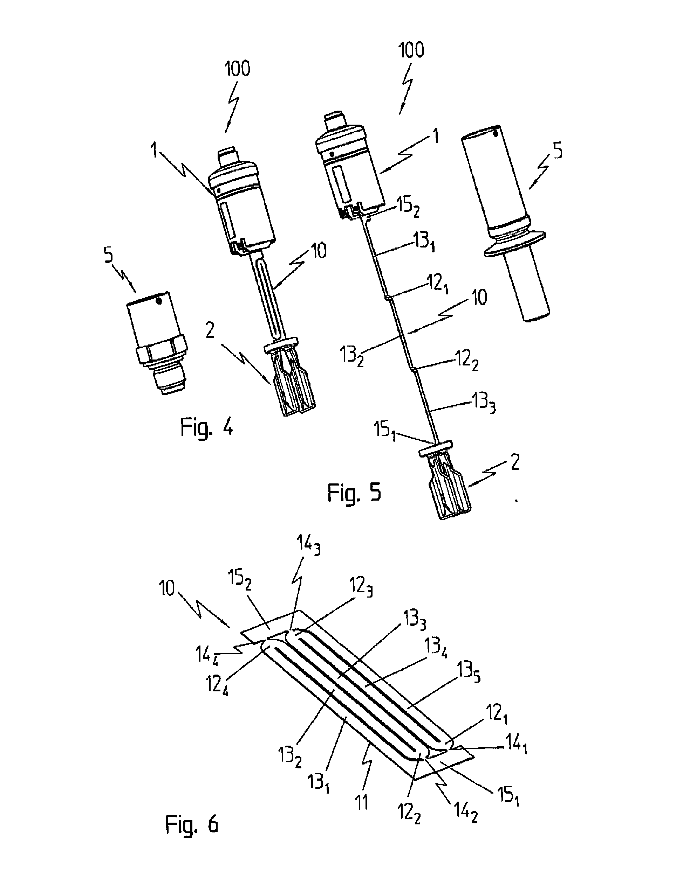

Das Anschlusskabel 10 gemäß Figur 1 kann in seinem Herstellungszustand verwendet werden, in welchem es eine Standardlänge aufweist und zur Verbindung von elektrischen Baugruppen verwendet werden kann. Eine solche Verwendung zeigt Figur 4, bei welcher die Standardlänge der Verbindungskabels 10 zur elektrischen Verbindung eines Messwertaufnehmers 2 und einer Auswerteelektronik 1 einer Messbaugruppe 100, die als Füllstandsmessgerät ausgebildet ist, ausreichend ist. Hierzu werden die Anschlusspads 4 des Leiterplattenendabschnitts 15₁ mit dem Messwertaufnehmer 2 elektrisch verbunden und die Anschlusspads 4 des anderen Leiterplattenendabschnitts 15₂ mit der Auswerteelektronik 2. Die beiden Komponenten dieser Messbaugruppe 100, der Messwertaufnehmer 2 und die Auswerteelektronik 1 werden von einem zylinderförmigen Gehäuse 5 aufgenommen, wobei diese Komponenten jeweils an einer Stirnseite dieses Gehäuses 5 montiert werden, wobei wegen besserer Übersichtlichkeit in Figur 4 das Gehäuse separat dargestellt ist. Figur 11 zeigt das Füllstandsmessgerät 100 im zusammengebauten Zustand in einer kurzen Baulänge.

Sollte diese Standardlänge des Verbindungskabels 10 nicht ausreichend sein, können durch Brechen der Stege 14₁ und 14₂ die Leiterplattenabschnitte 13₁ und 13₂ an den Biegeabschnitten 12₁ und 12₂ aufgefaltet werden, wie dies in Figur 2 dargestellt ist. Dadurch wird die Standardlänge um ca. zwei Leiterplattenabschnitte verlängert. Die entsprechende Anwendung zeigt Figur 5, wonach mit diesem verlängerten Verbindungskabel 10 ebenso ein Messwertaufnehmer 2 mit einer Auswerteelektronik 1 einer als Füllstandsmessgerät ausgebildeten Messbaugruppe 100 elektrisch verbunden wird. Im Unterschied zur Messbaugruppe 100 gemäß Figur 4 ist jedoch das zugehörige Gehäuse 5 dieser Messbaugruppe 100 nach Figur 5 wesentlich länger, so dass im zusammengebauten Zustand dieser Messbaugruppe 100 gemäß Figur 12 deren Baulänger ebenfalls größer ist.

Die Montage der Komponenten dieser Messbaugruppen 100 gemäß den Figuren 4 und 5 erfolgt derart, dass zunächst der Messwertaufnehmer 2 mit dem Verbindungskabel 10 über die Anschlussstellen 4 des Leiterplattenendabschnittes 15₁ elektrisch verbunden wird, anschließend wird der Messwertaufnehmer 2 mit dem Verbindungskabel 10 an einer Stirnseite des Gehäuses 5 montiert, so dass dabei der andere Leiterplattenendabschnitt 15₂ am anderen Ende des Gehäuses 5 hinausragt, um dort die Auswerteelektronik 1 mit den Anschlussstellen 4 dieses anderen Leiterplattenendabschnittes 15₂ elektrisch verbinden zu können. Zum Schluss wird auch diese Auswerteelektronik 1 an das Gehäuse 5 montiert, so dass der Zustand gemäß den Figuren 11 und 12 erreicht wird.

Somit kann ein solcher Messwertaufnehmer 2 zusammen mit dem Verlängerungskabel 10 als Vorbaugruppe hergestellt werden, die dann für Messbaugruppen 100 mit unterschiedlichen Baulängen einsetzbar sind.

Figur 6 zeigt ein Verbindungskabel 10, bei dem der Einfachheit halber die Leiterbahnen nicht dargestellt sind, jedoch im Prinzip entsprechend des Verbindungskabels gemäß Figur 1 ausgestaltet sind. Der Unterschied zum Anschlusskabel 10 gemäß Figur 1 besteht darin, dass die Leiterplatte 11 nicht aus drei Leiterplattenabschnitten, sondern aus fünf parallel angeordneten Leiterplattenabschnitten 13₁, 13₂, 13₃, 13₄ und 13₅ besteht und statt jeweils eines Biegeabschnitts auf gegenüberliegenden Seiten sind auf beiden Seiten jeweils zwei Biegeabschnitte 12₁ und 12₂ bzw. 12₃ und 12₄ vorgesehen, die entsprechende Leiterplattenabschnitte 13₁, 13₂, 13₃, 13₄ und 13₅ miteinander verbinden. Auch bei dieser Ausführung enden die äußeren Leiterplattenabschnitte 13₁ und 13₅ jeweils in einem die Biegeabschnitte 12₁ und 12₂ bzw. 12₃ und 12₄ überragenden ersten und zweiten rechteckförmig ausgebildeten Leiterplattenendabschnitt 15₁ und 15₂, wobei sich diese ebenso senkrecht zur Richtung der Leiterplattenabschnitte 13₁, 13₂, 13₃, 13₄ und 13₅ über deren gesamte Breite erstrecken und Anschlussstellen des Anschlusskabels 10 darstellen. Die Leiterplattenendabschnitte 15₁ und 15₂ sind mit den Biegeabschnitten 12₁ und 12₂ bzw. 12₃ und 12₄ jeweils mit Stegen 14₁ und 14₂ bzw. 14₃ und 14₄ trennbar verbunden.

Auch dieses Verbindungskabel 10 gemäß Figur 6 weist mit seinen Anschlussstellen 15₁ und 15₂ eine Standardlänge zur Verbindung von Baugruppen auf und kann bedarfsgemäß durch Brechen der Stege 14₁ bis 14₄ um maximal ca. vier Längen eines Leiterplattenabschnittes verlängert werden, indem die Leiterplattenabschnitte 13₁ bis 13₅ an den Biegestellen 12₁ bis 12₄ aufgefaltet werden.

Natürlich ist es auch möglich, bspw. nur die Stege 14₁ und 14₃ und 14₄ zu brechen, so dass der Leiterplattenendabschnitt 15₁ mit zwei Leiterplattenabschnitten 13₄ und 13₅ aufgefaltet werden können, um somit anstelle einer fünffachen nur eine dreifache Standardlänge zu erhalten.

Die Verbindungskabel 10 gemäß den Figuren 1 und 6 weisen als Ausführungsbeispiele eine Anzahl von (2n+1) Leiterplattenabschnitte mit n=1 und n=3 auf. Natürlich können auch Verbindungskabel mit einer größeren Anzahl, also mit n>3 realisiert werden.

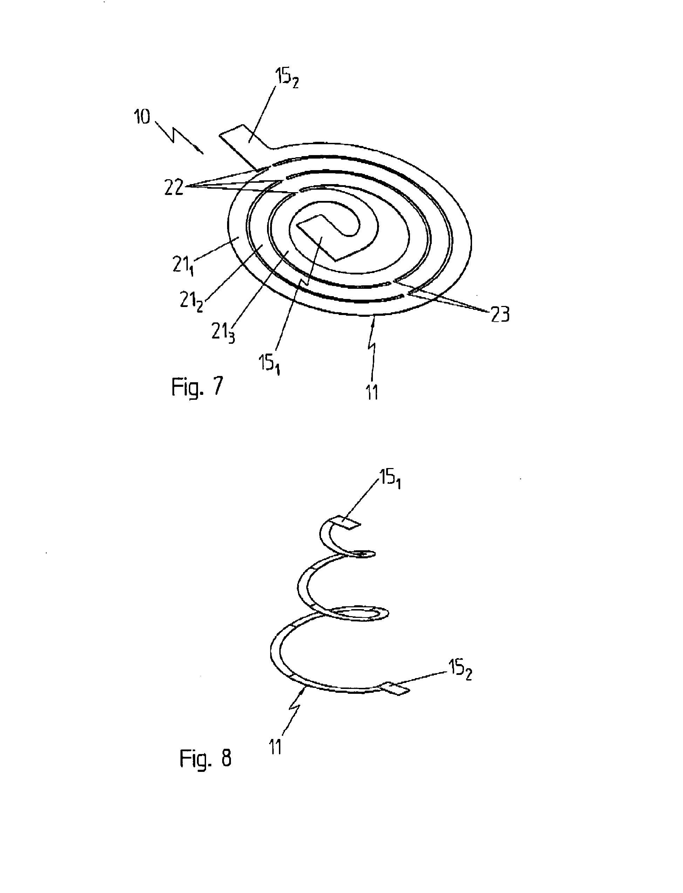

Das weitere Ausführungsbeispiel eines Verbindungskabels 10 ist gemäß Figur 7 in einer Ebene als spiralförmige Leiterplatte 11 ausgebildet, wobei auch hier auf die Darstellung der Leiterbahnen verzichtet ist.

Die spiralförmige Struktur dieser Leiterplatte 11 beginnt mit einem ersten Leiterplattenendabschnitt 15₁ und verläuft spiralförmig in einer Ebene mit mehreren Spiralgängen 21₁, 21₂ und 21₃ nach außen und endet in einem zweiten Leiterplattenendabschnitt 15₂. Zwischen den Spiralgängen 21₁, 21₂ und 21₃ sind jeweils Stege 22 und 23 vorgesehen sind, welche diese trennbar verbinden. Dabei sind die Stege 22 mit dem zweiten Leiterplattenendabschnitt 15₂ fluchtend auf der gleichen Seite der Spiralstruktur angeordnet, während auf der anderen Seite, also mit einer Differenz von einem halben Spiralgang die anderen Stege 23 die Spiralgänge verbinden, wobei alle Stege 22 und 23 auf einem Durchmesser der Spiralstruktur liegen.

Durch Brechen der Stege 22 und 23 kann diese ebene Spiralstruktur in eine räumliche Struktur entfaltet werden, so dass sich eine konische Spiralform des Verbindungskabels 10 mit maximaler Länge zwischen den als Anschlussstellen des Verbindungskabels 10 ausgebildeten Leiterplattenendabschnitte 15₁ und 15₂ ergibt, wie dies in Figur 8 dargestellt ist.

Auch ist es möglich, eine kürzere Kabellänge als die maximale Länge zu realisieren, indem ausgehend vom ersten, zentrisch angeordneten Leiterplattenendabschnitt 15₁ Stege 22 und 23 herausgebrochen werden, so dass wenigstens ein Spiralgang 21₃ aus der Ebene der Spiralstruktur heraus gefaltet bzw. gebogen werden kann.

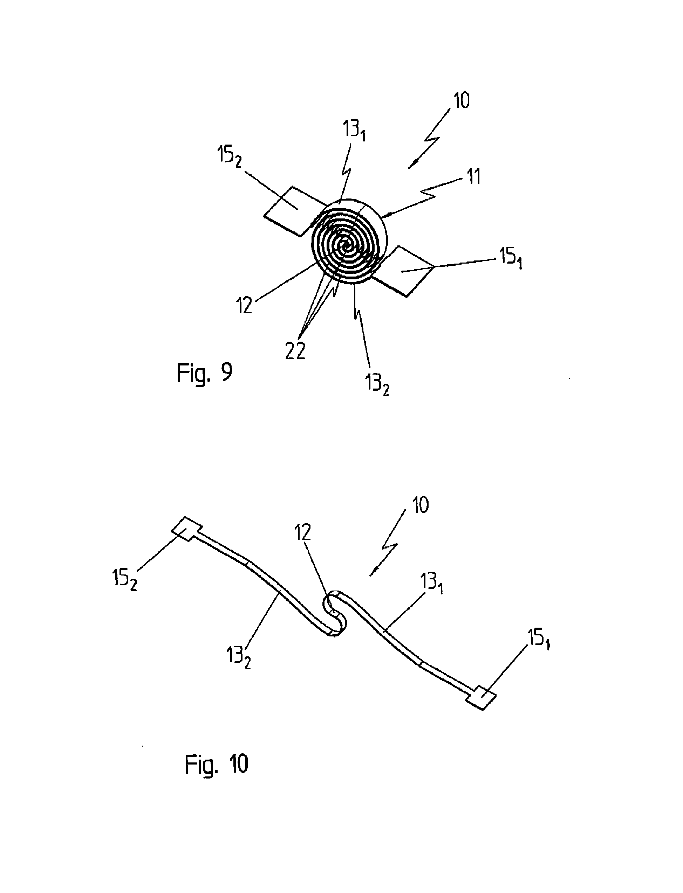

Schließlich weist gemäß Figur 9 das letzte Ausführungsbeispiel eines Verbindungskabels 10 ebenso eine spiralförmige Struktur auf, bei der jedoch die Leiterplatte 11 nicht in der Ebene spiralförmig verläuft, sondern senkrecht zur Ebene der Leiterplatte 11 spiralförmig mit mehreren Spiralgängen 22 nach außen verlaufend aufgewickelt ist. Dieses Verbindungskabel 10 besteht aus zwei streifenförmigen flexiblen Leiterplattenabschnitten 13₁ und 13₂, die beginnend mit einem diese beiden Leiterplattenabschnitte 13₁ und 13₂ verbindenden Biegeabschnitt 12 bifilar senkrecht zur Ebene der Leiterplatte 11 spiralförmig mit mehreren Spiralgängen 22 nach außen verlaufend mit Leiterplattenendabschnitten 15₁ und 15₂ endend gerollt ausgebildet sind, wobei diese beiden rechteckförmigen Leiterplattenendabschnitte 15₁ und 15₂ diametral gegenüberliegend angeordnet sind, also mit einer Differenz von einem halben Spiralgang 22.

Wie Figur 10 zeigt, kann dieses Verbindungskabel 10 stufenlos durch Entrollen der Spirale bis auf eine maximale Länge verlängert werden, wobei durch Teilentrollen jede gewünschte kürzere Länge erzielbar ist.

Mehrere Verbindungskabel 10 gemäß den Figuren 9 und 10 können in einem Träger (Nutzen), der in den Figuren nicht dargestellt ist, als einzelne Leiterplatten 11 zusammengefasst werden, indem diese in einem solchen Träger parallel angeordnet und benachbarte Leiterplatten 11 im Bereich der Spiralgänge 22 und/oder im Bereich der Leiterplattenendabschnitte 15₁ und 15₂ über Stege trennbar verbunden sind. Somit können die Verbindungskabel 10 durch Brechen dieser Stege durch Vereinzelung der Leiterplatten 11 erzeugt werden.

### Bezugszeichen

- 1: Auswerteelektronik
- 2: Messwertaufnehmer
- 3: Leiterbahn
- 4: Anschlusspad
- 5: Gehäuse

- 10: Verbindungskabel
- 11: Leiterplatte
- 12, 12₁, 12₂, 12₃, 12₄: Biegeabschnitt
- 13₁, 13₂, 13₃, 13₄, 13₅: Leiterplattenabschnitt
- 14₁, 14₂, 14₃, 14₄: Steg
- 15₁, 15₂: Leiterplattenendabschnitte
- 16: Stege
- 17: Stege
- 18: Randabschnitt des Trägers 20
- 19: Randabschnitt des Trägers 20

- 20: Träger, Nutzen
- 21₁, 21₂, 21₃: Spiralgänge
- 22: Stege
- 23: Stege

- 100: Messbaugruppe

- S: Schlitz

## Patentansprüche

1. Verbindungskabel (10) zur elektrischen Verbindung eines Messwertaufnehmers (2) und einer Auswerteelektronik (1) einer Messbaugruppe (100), insbesondere einer Baugruppe für Füllstandsmesstechnik, wobei das Verbindungskabel (10) als flexible Leiterplatte (11) mit wenigstens einer Leiterbahn (3) ausgebildet ist und die flexible Leiterplatte (11) wenigstens zwei aneinander liegende und über wenigstens einen Biegeabschnitt (12) verbundene Leiterplattenabschnitte (13) umfasst sowie aneinander liegende Bereiche der flexiblen Leiterplatte (11) wenigstens über einen Steg (14) trennbar verbunden sind,
**dadurch gekennzeichnet, dass**
- die Leiterplatte (11) mit einem ersten und zweiten Leiterplattenendabschnitt (15₁, 15₂) und dazwischen liegenden aus einer Anzahl von 2n+1 (n≥1) von im Wesentlichen gleich langen Leiterplattenabschnitten (13₁, 13₂, 13₃, 13₄, 13₅) ausgebildet ist,
- die Leiterplattenendabschnitte (15₁, 15₂) als Anschlussstellen in Richtung der Leiterplattenabschnitte (13₁, 13₂, 13₃, 13₄, 13₅) gegenüberliegende Biegeabschnitte (12₁, 12₂, 12₃, 12₄) überragend ausgebildet sind, wobei deren Ausdehnung quer zur Richtung der Leiterplattenabschnitte (13₁, 13₂, 13₃, 13₄, 13₅) im Wesentlichen der Breite der aneinander liegenden Leiterplattenabschnitte (13₁, 13₂, 13₃, 13₄, 13₅) entspricht,
- der erste Leiterplattenabschnitt (15₁) als Anschlussstelle mit dem Messwertaufnehmer (2) und der zweite Leiterplattenabschnitt (15₂) als Anschlussstelle mit der Auswerteelektronik (1) verbunden ist, und
die Leiterplattenendabschnitte (15₁, 15₂) mit den benachbarten Biegeabschnitten (12₁, 12₂, 12₃, 12₄) jeweils mit wenigstens einem Steg (14₁, 14₂, 14₃, 14₄) trennbar verbunden sind, wodurch eine Verlängerung des Verbindungskabel (10) zur Anpassung von dessen Länge an den Abstand zwischen dem Messwertaufnehmer (2) und der Auswerteelektronik (1) ermöglicht wird.

2. Verbindungskabel (10) nach Anspruch 1,
**dadurch gekennzeichnet, dass** die Leiterplattenabschnitte (13₁, 13₂, 13₃, 13₄, 13₅) geradlinig und parallel aneinander liegend ausgebildet sind.

3. Verbindungskabel (10) nach Anspruch 1 oder 2,
**dadurch gekennzeichnet, dass** die Leiterplattenendabschnitte (15₁, 15₂) als Anschlussstellen im Wesentlichen rechteckförmig ausgebildet sind.

4. Verbindungskabel (10) nach einem der vorhergehenden Ansprüche,
**dadurch gekennzeichnet, dass** bei einer Leiterplatte (11) mit wenigstens 2n+1 (n≥3) Leiterplattenabschnitten (13₁, 13₂, 13₃, 13₄, 13₅) die Leiterplattenendabschnitte (15₁, 15₂) jeweils mit allen benachbarten Biegeabschnitten (12₁, 12₂, 12₃, 12₄) über trennbare Stege (14₁, 14₂, 14₃, 14₄) verbunden sind.

5. Verbindungskabel (10) nach einem der vorhergehenden Ansprüche,
**dadurch gekennzeichnet, dass**
- eine Mehrzahl von Leiterplatten (11) in einem Träger (20) hinsichtlich der Leiterplattenabschnitte (13₁, 13₂, 13₃) parallel angeordnet sind, und
- benachbarte Leiterplatten (11) jeweils im Bereich der Leiterplattenendabschnitte (15₁, 15₂) über Stege (16, 17) trennbar verbunden sind.

6. Verbindungskabel (10) nach Anspruch 5,
**dadurch gekennzeichnet, dass** die jeweils über einen Steg (16, 17) miteinander verbundenen ersten bzw. zweiten Leitplattenendabschnitte (15₁, 15₂) der Leiterplatten (11) jeweils zusammen einen Randabschnitt (18, 19) des Trägers (20) bilden.

7. Verbindungskabel (10) nach Anspruch 6,
**dadurch gekennzeichnet, dass** die Stege (16, 17) jeweils randseitig der Randabschnitte (18, 19) angeordnet sind.

8. Verbindungskabel (10) nach Anspruch 6 oder 7,
**dadurch gekennzeichnet, dass** die beiden Randabschnitte (18, 19) gegenüberliegende Seiten eines im Wesentlichen rechteckförmig ausgebildeten Trägers (20) bilden.

9. Verbindungskabel (10) zur elektrischen Verbindung eines Messwertaufnehmers (2) und einer Auswerteelektronik (1) einer Messbaugruppe (100), insbesondere einer Baugruppe für Füllstandsmesstechnik, wobei das Verbindungskabel (10) als flexible Leiterplatte (11) mit wenigstens einer Leiterbahn (3) ausgebildet ist,
**dadurch gekennzeichnet, dass**
- die flexible Leiterplatte (11) beginnend mit einem ersten Leiterplattenendabschnitt (15₁) spiralförmig in einer Ebene mit mehreren Spiralgängen (21₁, 21₂, 23₃) nach außen verlaufend und in einem zweiten Leiterplattenendabschnitt (15₂) endend ausgebildet ist,
- der erste Leiterplattenabschnitt (15₁) als Anschlussstelle mit dem Messwertaufnehmer (2) und der zweite Leiterplattenabschnitt (15₂) als Anschlussstelle mit der Auswerteelektronik (1) verbunden ist, und
- zwischen den Spiralgängen (21₁, 21₂, 23₃) jeweils Stege (22, 23) vorgesehen sind, welche benachbarte Spiralgänge (21₁, 21₂, 23₃) der Leiterplatte (11) trennbar verbinden, wodurch eine Verlängerung des Verbindungskabel (10) zur Anpassung von dessen Länge an den Abstand zwischen dem Messwertaufnehmer (2) und der Auswerteelektronik (1) ermöglicht wird.

10. Verbindungskabel (10) nach Anspruch 9,
**dadurch gekennzeichnet, dass** nach jeweils einem halben Spiralgang (21₁, 21₂, 23₃) ein Steg (22, 23) vorgesehen ist.

11. Verbindungskabel (10) nach einem der Ansprüche 9 bis 10,
**dadurch gekennzeichnet, dass** wenigstens ein Steg (22) im Bereich des zweiten Leiterplattenendabschnittes (15₁) vorgesehen ist.

12. Verbindungskabel (10) zur elektrischen Verbindung eines Messwertaufnehmers (2) und einer Auswerteelektronik (1) einer Messbaugruppe (100), insbesondere einer Baugruppe für Füllstandsmesstechnik, wobei das Verbindungskabel (10) als flexible Leiterplatte (11) mit wenigstens einer Leiterbahn (3) ausgebildet ist,
**dadurch gekennzeichnet, dass**
- zwei flexible Leiterplattenabschnitte (13₁, 13₂) beginnend mit einem die Leiterplattenabschnitte (13₁, 13₂) verbindenden Biegeabschnitt (12) bifilar senkrecht zur Ebene der Leiterplatte (11) spiralförmig mit mehreren Spiralgängen (22) nach außen verlaufend mit Leiterplattenendabschnitten (15₁, 15₂) endend gerollt ausgebildet sind,
- ein erster Leiterplattenabschnitt (15₁) als Anschlussstelle mit dem Messwertaufnehmer (2) und ein zweite Leiterplattenabschnitt (15₂) als Anschlussstelle mit der Auswerteelektronik (1) verbunden ist, und
- eine Verlängerung des Verbindungskabels (10) zur Anpassung von dessen Länge an den Abstand zwischen dem Messwertaufnehmer (2) und der Auswerteelektronik (1) durch Entrollen des Verlängerungskabels (10) ermöglicht wird.

13. Verbindungskabel (10) nach Anspruch 12,
**dadurch gekennzeichnet, dass** zwischen den Leiterplattenendabschnitten (15₁, 15₂) eine Differenz von einem halben Spiralgang (22) vorgesehen ist.

14. Verbindungskabel (10) nach einem der Ansprüche 12 oder 13,
**dadurch gekennzeichnet, dass** eine Mehrzahl von flexiblen Leiterplatten (11) in einem Träger (Nutzen) parallel angeordnet sind, und
- benachbarte Leiterplatten (11) im Bereich der Spiralgänge (22) und/oder im Bereich der Leiterplattenendabschnitte (15₁, 15₂) über Stege trennbar verbunden sind.

15. Verbindungskabel (10) nach einem der Ansprüche 9 bis 14,
**dadurch gekennzeichnet, dass** die Leiterplattenendabschnitte (15₁, 15₂) als im Wesentlichen rechteckförmige Anschlussstellen ausgebildet sind.

16. Messbaugruppe (100) mit einem Gehäuse (5) zur Aufnahme eines Messwertaufnehmers (2) und einer Auswerteelektronik (1),
**dadurch gekennzeichnet, dass**
- der Messwertaufnehmer (2) und die Auswerteelektronik (1) über ein Verbindungskabel (10) nach einem der Ansprüche 1 bis 15 verbunden sind, und
- der erste Leiterplattenabschnitt (15₁) als Anschlussstelle mit dem Messwertaufnehmer (2) und der zweite Leiterplattenabschnitt (15₂) als Anschlussstelle mit der Auswerteelektronik (1) verbunden ist.

17. Messbaugruppe (100) nach Anspruch 16,
**dadurch gekennzeichnet, dass** entweder durch Brechen der Stege (14₁, 14₂, 14₃, 14₄) des Verbindungskabels (10) und dessen Auffalten oder durch Entrollen des Verbindungskabels (10) eine Verlängerung des Verbindungskabels (10) ermöglicht wird, um die Länge des Verbindungskabels (10) an den Abstand zwischen dem Messwertaufnehmers (2) und der Auswerteelektronik (1), welche in dem Gehäuse (5) angeordnet sind, anzupassen.

18. Messbaugruppe (100) nach Anspruch 16 oder 17,
**dadurch gekennzeichnet, dass** das Gehäuse (5) der Messbaugruppe (100) zylinderförmig ausgebildet ist, wobei auf gegenüberliegenden Stirnseiten des zylinderförmigen Gehäuses (5) der Messwertaufnehmer (2) und die Auswerteelektronik (1) angeordnet sind.

19. Messbaugruppe (100) nach Anspruch 17 oder 18,
**dadurch gekennzeichnet, dass** das Verbindungskabel (10) im aufgefalteten oder entrollten Zustand eine Länge aufweist, bei der der Messwertaufnehmer (2) und die Auswertelektronik (1) vor einer Montage mit dem zylinderförmigen Gehäuse (5) mit dem durch das Gehäuse (5) geführten Verbindungskabel (10) verbindbar sind.

20. Messbaugruppe (100) nach einem der Ansprüche 16 bis 18,
**dadurch gekennzeichnet, dass** die Messbaugruppe (100) zur Füllstandsmessung ausgebildet ist.
